(19) Europäisches Patentamt
European Patent Office
Office européen des brevets

(11) EP 4 163 954 A1

(12) EUROPEAN PATENT APPLICATION
published in accordance with Art. 153(4) EPC

(43) Date of publication:
12.04.2023 Bulletin 2023/15

(21) Application number: 21818434.9

(22) Date of filing: 27.05.2021

(51) International Patent Classification (IPC):
H01L 21/02 (2006.01)    H01L 27/12 (2006.01)

(52) Cooperative Patent Classification (CPC):
H01L 21/02; H01L 27/12

(86) International application number:
PCT/JP2021/020199

(87) International publication number:
WO 2021/246279 (09.12.2021 Gazette 2021/49)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 04.06.2020 JP 2020097711

(71) Applicant: Sumco Corporation
Minato-ku, Tokyo 105-8634 (JP)

(72) Inventors:
• SHIBUYA, Shota
Tokyo 105-8634 (JP)
• HIEDA, Daisuke
Tokyo 105-8634 (JP)
• ISHIZAKI, Hiroaki
Tokyo 105-8634 (JP)

(74) Representative: Hoffmann Eitle
Patent- und Rechtsanwälte PartmbB
Arabellastraße 30
81925 München (DE)

(54) **SUPPORT SUBSTRATE FOR BONDED WAFER**

(57) A handle wafer (23) used for a bonded wafer (30) that is produced by bonding an active wafer (13) and the handle wafer (23) through an insulation film (11) is provided. The handle wafer (23) includes a handle wafer body (20) and a polycrystalline silicon layer (22) deposited on a side close to a bonding surface of the handle wafer body (20). The polycrystalline silicon layer (22) has a polycrystalline silicon grain size of 0.419 μm or less.

F I G . 2

EP 4 163 954 A1

**Description**

TECHNICAL FIELD

The present invention relates to a handle wafer used for a bonded wafer produced by bonding an active wafer and the handle wafer.

BACKGROUND ART

Silicon On Insulator (SOI) wafers have been used as substrates for high-frequency (RF: Radio Frequency) devices. The SOI wafers include an insulation film made of, for instance, silicon oxide ($SiO_2$) and an active layer (e.g. monocrystalline silicon), which are sequentially layered on a handle wafer (e.g. monocrystalline silicon wafer).

One of typical methods for producing the SOI wafers is a bonding method. In the bonding method, the insulation film is formed on at least one of the handle wafer or the active wafer, and then these wafers are bonded through the insulation film. After that, the bonded wafer is subjected to heat treatment at a high temperature of approximately 1,200 degrees C to produce the SOI wafer (hereinafter, the SOI wafer produced by the bonding method will be referred to as a "bonded wafer").

In order to address RF in the bonded wafer, an increase in resistivity of the handle wafer has been performed (e.g. resistivity of 3000 Ω·cm or more). However, there is a demand for bonded wafers corresponding to higher frequency in response to the need for higher-speed devices, and only increasing the resistivity of the handle wafer becomes insufficient to meet the demand.

In view of the above, it has been proposed to provide, on a surface of the handle wafer, a polycrystalline silicon layer as a carrier trap layer that traps and annihilates carriers generated during a high-frequency operation (see, for instance, Patent Literature 1). In order to prevent epitaxial growth of silicon on the monocrystalline silicon of the handle wafer, an ultra-thin oxide film is formed on the handle wafer and polycrystalline silicon is formed on the ultra-thin oxide film. A surface provided with the polycrystalline silicon is polished and then bonded with an insulation film formed on the active layer.

Further, Patent Literature 1 discloses a two-step growth method of the polycrystalline silicon layer in order to prevent an increase in warpage of the bonded wafer that may otherwise be caused by the thickness of the polycrystalline silicon layer, and partial dissipation of the ultra-thin oxide film due to a high growth temperature and consequent epitaxial growth. According to the above method, the polycrystalline silicon layer is deposited in two steps including a first growth step of growing a first polycrystalline silicon layer and a second growth step of growing a second polycrystalline silicon layer thicker than the first polycrystalline silicon layer.

CITATION LIST

PATENT LITERATURE(S)

Patent Literature 1: JP 2015-211061 A

SUMMARY OF THE INVENTION

PROBLEM(S) TO BE SOLVED BY THE INVENTION

However, when a surface of the bonded wafer produced as above is observed with an optical microscope or the like, microprojections having a diameter ranging from several tens of micrometers to several millimeters, which swell like blisters, are often seen on a part of the surface of the wafer. These are called blister defects, which are formed because the wafers are not suitably bonded at a bonding interface. The blister defects cause various problems. For instance, the blister defects cause malfunction on a device formed at the part with the defects. Further, a part of the active layer that is positioned on the defects is liable to be peeled to be a dust source during the device production process.

Presumably, causes of failure in suitably bonding the wafers at the bonding interface are warpage of the handle wafer and surface roughness of the surface of the polycrystalline silicon layer. When the polycrystalline silicon layer is formed by the method disclosed in Patent Literature 1, the warpage of the handle wafer is restrained. It is thus believed that the blister defects are caused by the surface roughness after surface polishing.

An object of the invention is to provide a handle wafer for a bonded wafer capable of inhibiting development of the blister defects when the bonded wafer is produced.

MEANS FOR SOLVING THE PROBLEM(S)

A handle wafer according to an aspect of the invention, which is used for a bonded wafer produced by bonding an active wafer and the handle wafer through an insulation film, includes: a handle wafer body; and a polycrystalline silicon layer deposited on a side close to a bonding surface of the handle wafer body, in which the polycrystalline silicon layer has a polycrystalline silicon grain size of 0.419 $\mu$m or less.

In the handle wafer for a bonded wafer according to the above aspect of the invention, a root-mean-square roughness Rq of the polycrystalline silicon layer measured in an area of 10 $\mu$m $\times$ 10 $\mu$m is optionally 0.364 nm or less after the polycrystalline silicon layer is polished.

In the handle wafer for a bonded wafer according to the above aspect of the invention, the polycrystalline silicon layer is polished and BOW-bf indicating deviation from a center reference plane of the handle wafer to a median surface at a center point of the handle wafer is optionally +16 $\mu$m or less.

In the handle wafer for a bonded wafer according to the above aspect of the invention, the polycrystalline silicon layer optionally includes a first polycrystalline silicon layer deposited on the side close to the bonding surface of the handle wafer body and a second polycrystalline silicon layer deposited on the first polycrystalline silicon layer, and the polycrystalline silicon grain size is optionally a polycrystalline silicon grain size of the second polycrystalline silicon layer.

The handle wafer body is optionally a monocrystalline silicon wafer.

According to the above aspect of the invention, development of blister defects can be inhibited when a bonded wafer is produced.

BRIEF EXPLANATION OF DRAWINGS

Fig. 1 is a flow chart for illustrating a process for producing a bonded wafer according to an exemplary embodiment of the invention.
Fig. 2 is a cross-sectional view showing steps of a production method of the bonded wafer according to the exemplary embodiment of the invention.
Fig. 3 is a graph showing a relationship between a deposition temperature and a blister defect area of a polycrystalline silicon layer.
Fig. 4 is a graph showing a relationship between a grain size and a root-mean-square roughness.

DESCRIPTION OF EMBODIMENT(S)

Suitable exemplary embodiments of the invention will be described in detail below with reference to the attached drawings. A handle wafer for a bonded wafer of the invention is, for instance, used for a bonded wafer (e.g. the SOI wafer), which is obtained by bonding the handle wafer to an insulation film formed on an active wafer.

Inventors of the invention have made dedicated studies on the handle wafer for the bonded wafer capable of inhibiting the development of blister defects. As a result, the inventors have found a range of the surface roughness (root-mean-square roughness Rq, RMS) of a polycrystalline silicon layer that may inhibit the development of blister defects. Further, the inventors have found a correlation between the surface roughness and a polycrystalline silicon grain size of the polycrystalline silicon layer, thereby reaching the invention.

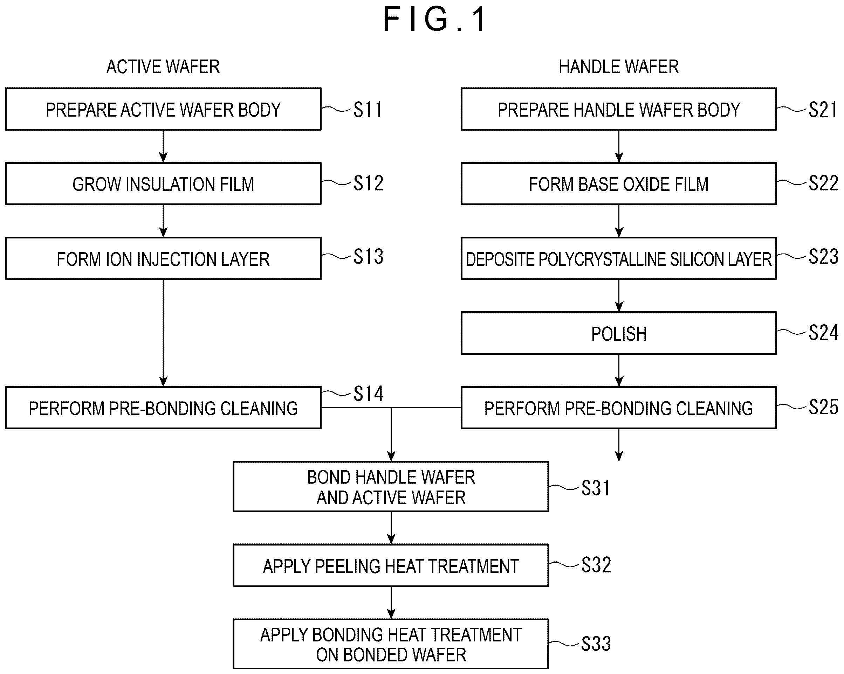

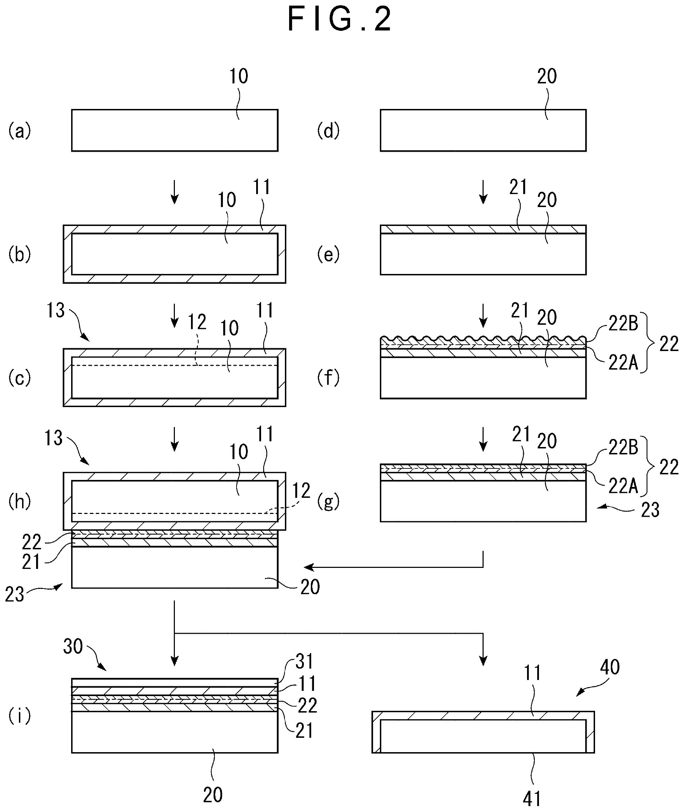

Fig. 1 is a flowchart for illustrating a process for producing the bonded wafer of the exemplary embodiment. Fig. 2 is a cross-sectional view showing steps of a production method of the bonded wafer.

As shown in Figs. 1 and 2, the production method of the bonded wafer includes steps S11 to S14 for producing an active wafer, steps S21 to S25 for producing a handle wafer independently of the active wafer, and steps S31 to S33 for producing the bonded wafer by bonding the active wafer and the handle wafer.

The steps for producing the active wafer includes an active wafer body preparation step S11, an insulation film growth step S12, an ion implantation layer formation step S13, and a pre-bonding cleaning step S14.

In the active wafer body preparation step S11, an active wafer body 10 in a form of a monocrystalline silicon wafer is prepared.

In the insulation film growth step S12, an insulation film 11 (oxide film) is grown around the active wafer body 10 through, for instance, thermal oxidation, CVD, or the like.

In the ion implantation layer formation step S13, an ion implantation layer 12 is formed in the active wafer body 10 by implanting hydrogen ion or rare gas ion from above the insulation film 11 using an ion implanter.

In the pre-bonding cleaning step S14, the active layer is cleaned before being bonded in order to remove particles on a bonding surface of the active wafer body 10.

The active wafer 13 for the bonded wafer is produced through the above steps.

The steps for producing the handle wafer include a handle wafer body preparation step S21, an oxide film formation step S22, a polycrystalline silicon layer deposition step S23, a polishing step S24, and a pre-bonding cleaning step S25.

In the handle wafer body preparation step S21, a handle wafer body 20 formed from a monocrystalline silicon wafer is prepared. The monocrystalline silicon wafer may be produced by slicing a monocrystalline silicon ingot, which is grown by Czochralski method (CZ method) or floating zone melting method (FZ method), using a wire saw or the like.

In the oxide film formation step S22, an oxide film 21 (base oxide film) is formed on the handle wafer body 20. Preferably, the thickness of the oxide film 21 is, for instance, in a range from 0.3 nm to 10 nm. With the reduced thickness of the oxide film 21, the oxide film 21 interposed between the handle wafer body 20 and the polycrystalline silicon layer 22 hardly affects properties of the RF device.

The oxide film 21 may be formed through, for instance, wet cleaning such as alkali cleaning (SC1 cleaning) or acid cleaning (SC2 cleaning). The oxide film 21 may be formed by any other method, for example, by thermal oxidation under an oxidative atmosphere or oxidation heat treatment using a rapid heating/cooling device.

In the polycrystalline silicon layer deposition step S23, the polycrystalline silicon layer 22 is deposited on the oxide film 21. The polycrystalline silicon layer 22 is deposited in two steps including a first growth step for growing a first polycrystalline silicon layer 22A and a second growth step for growing a second polycrystalline silicon layer 22B thicker than the first polycrystalline silicon layer 22A.

A growth temperature (first temperature) in the first growth step initially performed is in a range from 890 degrees C to 900 degrees C. The growth temperature in the first growth step is preferably 895 degrees C.

A growth temperature (second temperature) in the second growth step performed subsequently to the first growth step is preferably in a range from 1,000 degrees C to 1,075 degrees C, more preferably in a range from 1,050 degrees C to 1,075 degrees C.

Single crystallization of the polycrystalline silicon layer 22 caused by dissipation of a part of the oxide film 21 can be prevented by forming the oxide film 21 in advance between the surface of the handle wafer body 20 and the polycrystalline silicon layer 22 and by setting the first temperature during the subsequent first growth step in a range from 890 degrees C and 900 degrees C. Further, warpage after polishing can be reduced.

The second polycrystalline silicon layer 22B is deposited in the second growth step at the second temperature ranging from 1,000 degrees C to 1,075 degrees C to have a thickness larger than that in the first growth step, making it possible to reduce warpage of the handle wafer 23 while the polycrystalline silicon layer 22 is deposited to have a sufficient thickness at efficient high-speed. The warpage of the handle wafer 23 can be further reduced by setting the second temperature at 1,050 degrees C or more.

The warpage of the exemplary embodiment is evaluated in terms of BOW (orientation and dimension of warpage) after polishing. BOW, which is one of indexes representing the warpage of the entirety of the wafer, is represented by deviation from a center reference plane of a wafer (handle wafer 23) to a median surface at a center point of the wafer. The center reference plane of the invention is defined on a basis of best-fit (BOW-bf). Accordingly, a plus (+) BOW-bf value shows convex warpage, whereas a minus (-) BOW-bf value shows concave warpage. For instance, the warpage may be measured using an optical-sensor type flatness measuring device (Wafercom produced by Lapmaster SFT Corp.) or the like.

In the polishing step S24, a surface of the polycrystalline silicon layer 22 (the second polycrystalline silicon layer 22B) deposited on the handle wafer body 20 is polished to be flattened.

In the pre-bonding cleaning step S25, particles on the polished surface of the polycrystalline silicon layer 22 are removed.

The handle wafer 23 for the bonded wafer is produced through the above steps. It should be noted that the steps S11 to S14 and the steps S21 to S25 may be performed in parallel.

Next, a process for bonding the active wafer 13 and the handle wafer 23 to produce a bonded wafer 30 will be described below.

The process for producing the bonded wafer includes a bonding step S31, a peeling heat treatment step S32, and a bonding heat treatment step S33.

In the bonding step S31, the polished surface of the polycrystalline silicon layer 22 of the handle wafer 23 and the active wafer 13 are bonded through the insulation film 11. At this time, the active wafer 13 and the handle wafer 23 are bonded so that an implantation surface of the active wafer 13 faces the polycrystalline silicon layer 22.

In the peeling heat treatment step S32, the ion implantation layer 12 is subjected to heat treatment (peeling heat treatment) for generating microbubbles to peel the ion implantation layer 12 with the generated microbubbles. The bonded wafer 30, in which the insulation film 11 and an active layer 31 are formed on the active wafer 13, is thus produced. It should be noted that a peeled wafer 40 having a peeling surface 41 is also produced.

In the bonding heat treatment step S33, the bonded wafer 30 is subjected to bonding heat treatment to enhance the bonding strength at the bonding interface.

The bonded wafer 30 can be produced as described above.

The handle wafer 23 used in the above-described production method of the bonded wafer includes the first polycrystalline silicon layer 22A deposited on a side close to the bonding surface of the handle wafer body 20 and the second polycrystalline silicon layer 22B deposited on the first polycrystalline silicon layer 22A. Further, the polycrystalline silicon grain size of the polycrystalline silicon layer 22 is 0.419 $\mu$m or less by setting the second temperature (the growth temperature of the second polycrystalline silicon layer 22B) in a range from 1,000 degrees C to 1,075 degrees C. Furthermore, the root-mean-square roughness Rq of the polished polycrystalline silicon layer 22 measured in an area of 10 $\mu$m $\times$ 10 $\mu$m is 0.364 nm or less. Moreover, BOW-bf of the bonded wafer 30 is +16 $\mu$m or less. The above polycrystalline silicon grain size is a polycrystalline silicon grain size of the second polycrystalline silicon layer 22B.

The development of the blister defects is inhibited in the bonded wafer 30 produced with the use of the handle wafer 23 that satisfies the above requirements. Examples

In order to determine the growth temperature in depositing the polycrystalline silicon layer 22, the inventors produced the bonded wafer 30 at the growth temperatures shown in Examples, Comparatives, and Reference Examples. Conditions common to Examples, Comparatives, and Reference Examples are shown below.

Diameter of handle wafer: 200 mm
Crystal orientation of handle wafer: <100>
Resistivity of handle wafer: 12,060 $\Omega$·cm
Oxygen concentration of handle wafer: 2.99 $\times$ 10$^{17}$ atoms/cm$^3$
Base oxide film formation: SC1 cleaning; Oxide film thickness approximately 1 nm
BOX oxidation: 1,050 degrees C; Oxide film thickness 400 nm
Hydrogen ion implantation: 105 keV
Peeling heat treatment: 500 degrees C; 30 minutes; 100% Ar atmosphere
Bonding heat treatment: 900 degrees C pyrogenic oxidation + Ar annealing at 1,100 degrees C for 120 minutes.

Initially, the growth temperature for the first growth step (first temperature) was determined after the handle wafer 23 having only the first polycrystalline silicon layer 22A was produced at the growth temperature shown in each of Reference Examples 1 to 3 in Table 1 and the handle wafer 23 and the bonded wafer 30 produced using the handle wafer 23 were evaluated. Specifically, the handle wafer 23 was produced through only one step (i.e., the first step) for growing the first polycrystalline silicon layer 22A in the polycrystalline silicon layer deposition step S23 to perform evaluation. In Reference Example 3, the surface of the wafer was single-crystallized and was not polished, and thus BOW-bf after polishing was not measured.

Table 1

|  | Reference Ex. 1 850 degrees C (One Step) | Reference Ex. 2 895 degrees C (One Step) | Reference Ex. 3 950 degrees C (One Step) |
| --- | --- | --- | --- |
| Fist Temperature (degrees C) | 850 | 895 | 950 |
| Thickness of First Layer ($\mu$m) | 2.25 | 2.25 | 2.25 |
| Growth Rate ($\mu$m/min.) | 0.12 | 0.28 | 0.59 |
| BOW-bf ($\mu$m) | +49.3 | +31.4 | - |
| Crystalline State | Polycrystal | Polycrystal | Monocrystal |

As a result of the evaluation, it was found that BOW of the handle wafer 23 was large at the first temperature of 850 degrees C. Further, it was found that a part of the oxide film 21 on the surface of the handle wafer 23 was dissipated and the part was single-crystallized at the first temperature of 950 degrees C. In view of the above, the growth temperature in the first growth step was set at 895 degrees C. Further, it was confirmed that the first temperature in a range from 890 degrees C to 900 degrees C was safely applicable.

Subsequently, the growth temperature for the second growth step (second temperature) was determined after the handle wafer 23 was produced at the growth temperature shown in each of Examples 1 to 4 and Comparatives 1 to 3 in Table 2 and the handle wafer 23 and the bonded wafer 30 produced using the handle wafer 23 were evaluated.

Table 2

| | Reference Ex. 2 895 degrees C (One Step) | Ex. 1 895/1,000 degrees C (Two Steps) | Ex. 2 895/1,050 degrees C (Two Steps) | Ex. 3 895/1,070 degrees C (Two Steps) | Ex. 4 895/1,075 degrees C (Two Steps) | Comp. 1 895/1,080 degrees C (Two Steps) | Comp. 2 895/1,100 degrees C (Two Steps) | Comp. 3 895/1,150 degrees C (Two Steps) |
|---|---|---|---|---|---|---|---|---|
| First Temperature (degrees C) | 895 | 895 | 895 | 895 | 895 | 895 | 895 | 895 |
| Second Temperature (degrees C) | - | 1,000 | 1,050 | 1,070 | 1,075 | 1,080 | 1,100 | 1,150 |
| Growth Rate ($\mu$m/min.) | 0.280 | 0.687 | 0.775 | 0.794 | 0.799 | 0.809 | 0.814 | 0.930 |
| Root-Mean-Square Roughness Rq (nm) | 0.327 | 0.269 | 0.342 | 0.360 | 0.364 | 0.371 | 0.408 | 0.443 |
| Grain Size ($\mu$m) | 0.367 | 0.293 | 0.418 | 0.412 | 0.419 | 0.424 | 0.485 | 0.475 |
| Blister Defects Generated Area (mm2) | 0 | 0 | 0 | 0 | 0 | 39 | 161 | 277 |
| Thickness of First Layer ($\mu$m) | 2.25 | 0.3 | 0.3 | 0.3 | 0.3 | 0.3 | 0.3 | 0.3 |
| Thickness of Second Layer ($\mu$m) | - | 1.95 | 1.95 | 1.95 | 1.95 | 1.95 | 1.95 | 1.95 |
| Slip Determination Results | Passed | Passed | Passed | Passed | Passed | Failed | Failed | Failed |
| BOW-bf ($\mu$m) | +31.4 | +15.6 | +9.2 | +7.3 | +6.6 | +6.3 | +2.5 | +0.6 |

Example 1

The handle wafer 23 and the bonded wafer 30 were produced through the production method described with reference to Figs. 1 and 2. In Example 1, the polycrystalline silicon layer 22 was deposited at the deposition temperatures shown in Table 2 (i.e. the first temperature: 895 degrees C, the second temperature: 1,000 degrees C).

The surface roughness after polishing the polycrystalline silicon layer, the grain size, and BOW-bf of the produced handle wafer 23 were measured.

Further, the blister defect generated area of the bonded wafer 30 produced with the use of the handle wafer 23 was measured. Furthermore, the presence or absence of slip (a defect along the crystalline surface of silicon) was determined.

In order to determine the surface roughness, an area of 10 $\mu$m $\times$10 $\mu$m of the polished polycrystalline silicon layer 22 was measured with an Atomic Force Microscope (AFM) to calculate the root-mean-square roughness Rq.

The grain size was measured by an Electron Back Scatter Diffraction Patterns (EBSD) measurement device annexed to a Scanning Electron Microscope (SEM) after polishing. The EBSD measurement, which is a crystal analysis process in a form of the application of the principle of Electron Channeling Pattern (ECP) method, allows crystal analysis in a smaller submicron area. The grain size is calculated from a pattern obtained at the time of electron irradiation.

The blister defect area was measured using an optical microscope after the wafers were bonded.

Examples 2 to 4

The handle wafer 23 and the bonded wafer 30 were produced as in Example 1. It should be noted that the first and second temperatures were set at the temperatures shown in Table 2 in depositing the polycrystalline silicon layer 22.

Comparatives 1 to 3

The handle wafer 23 and the bonded wafer 30 were produced as in Examples 1 to 4. It should be noted that the first and second temperatures were set at the temperatures shown in Table 2 in depositing the polycrystalline silicon layer 22.

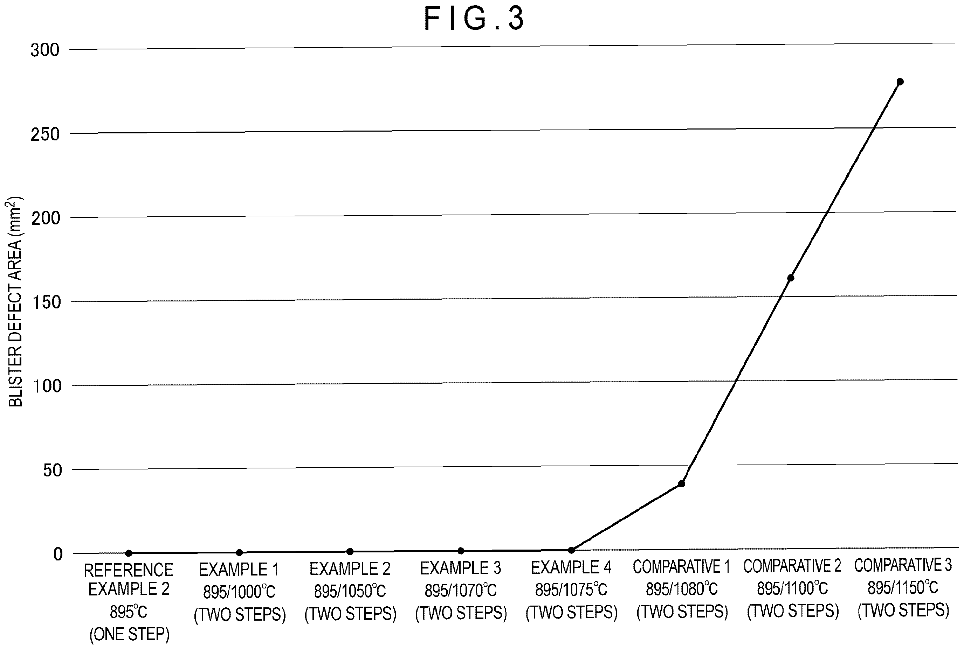

Fig. 3 is a graph showing a relationship between the deposition temperature and the blister defect area (horizontal axis: Examples, Comparatives, and Reference Examples (deposition temperature conditions), vertical axis: blister defect area). As shown in Table 1 and Fig. 3, it is found that the blister defects were correlated with the second temperature, that no blister defects were generated in Examples 1 to 4, and that the blister defects were generated in Comparatives 1 to 3 where the second temperature was 1,080 degrees C or more. Comparatives 1 to 3 reveal that the blister defect area is larger as the second temperature increases.

Based on the results, it is determined that the deposition temperature condition for inhibiting the blister defects is 895 degrees C for the first temperature and 1,000 degrees C or more and 1,075 degrees C or less for the second temperature.

Assumingly, causes of the blister defects include BOW-bf of the handle wafer 23 and the root-mean-square roughness Rq of the polycrystalline silicon layer 22. Since BOW-bf is equal to or less than +35.0 $\mu$m (i.e. acceptable value of BOW-bf) in all of Examples and Comparatives, the cause of the blister defects is believed to be the root-mean-square roughness Rq. Accordingly, the bonded wafer 30 that is not likely to have blister defects is producible by setting the root-mean-square roughness Rq at 0.364 nm or less in view of Table 2.

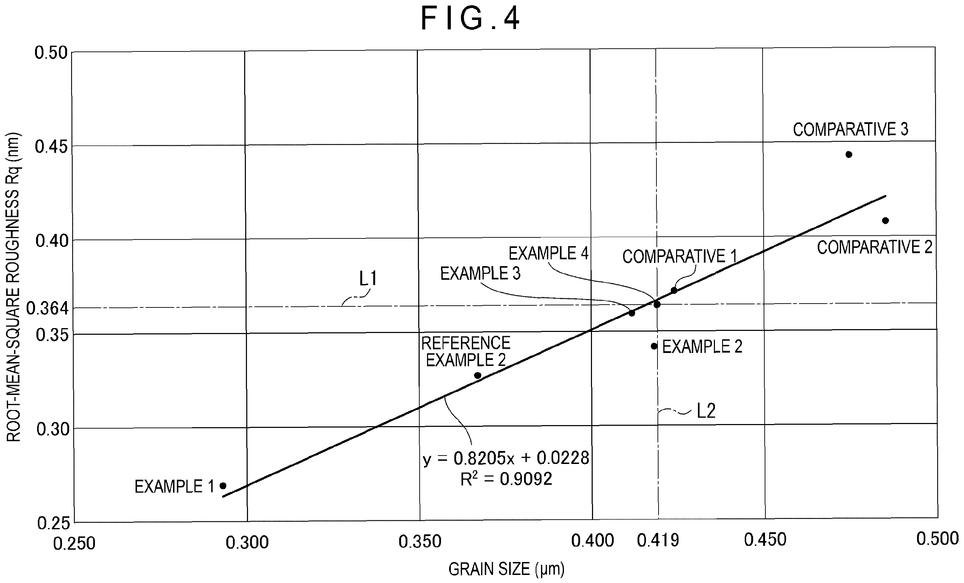

Fig. 4 is a graph showing a relationship between the grain size and the root-mean-square roughness Rq (horizontal axis: grain size, vertical axis: root-mean-square roughness Rq) of Examples, Comparatives, and Reference Example. A blister defect generation threshold (0.364 nm) of the root-mean-square roughness Rq is shown by a chain line L1 in Fig. 4.

Fig. 4 shows that the root-mean-square roughness Rq and the grain size are correlated. Specifically, a regression line can be determined based on plotted results of Examples, Comparatives, and Reference Example through the method of least squares. Assuming that the grain size is x and the root-mean-square roughness Rq is y, the regression line can be represented by Formula (1) below. The regression line is shown as a straight line in Fig. 4. A determination coefficient of the regression line is $R^2 = 0.9092$.

$$y = 0.8205x + 0.0228 \ldots (1)$$

Based on the correlation, it is found that the blister defects can be inhibited also by setting the grain size at 0.419 $\mu$m or less. A blister defect generation threshold (0.419 $\mu$m) of the grain size is shown by a chain line L2 in Fig. 4.

In regard to the presence or absence of slip, the results of cases where the second temperature was 1,080 degrees C or more (Comparatives 1 to 3) were unfavorable (failed). Assumingly, the high deposition temperature of the polycrystalline silicon layer 22 is a cause of the occurrence of slip defects.

In regard to the BOW-bf after polishing, the results show that BOW-bf is smaller as the second temperature is higher. In Examples 1 to 4, the case where the second temperature was 1,000 degrees C had the largest value (15.6 $\mu$m). However, since no blister defects were generated at the value, it is believed that no problem is caused provided that that BOW-bf is +16 $\mu$m or less. Further, the bonded wafer can have a further reduced BOW-bf by setting the second temperature at 1,050 degrees C or more.

In view of the above, it is found that the development of blister defects can be inhibited by setting the polycrystalline silicon grain size of the polycrystalline silicon layer 22 at 0.419 $\mu$m or less in the handle wafer 23 for the bonded wafer having the polycrystalline silicon layer 22.

Similarly, it is found that the development of blister defects can be inhibited by setting the root-mean-square roughness Rq of the polished polycrystalline silicon layer 22 at 0.364 nm or less.

It is also found that the bonded wafer 30 can have a BOW-bf of +16 $\mu$m or less by performing the polycrystalline silicon layer deposition step S23 in two steps.

It is further found that the development of blister defects can be inhibited by setting the second temperature in a range from 1,000 degrees C to 1,075 degrees C in the production method of the handle wafer for the bonded wafer.

EXPLANATION OF CODES

10...active wafer body, 11...insulation film, 12... ion implantation layer, 13...active wafer, 20...handle wafer body, 21...oxide film, 22...polycrystalline silicon layer, 22A...first polycrystalline silicon layer, 22B...second polycrystalline silicon layer, 23...handle wafer, 30...bonded wafer, 31...active layer, 40...peeled wafer, 41 ... peeling surface

**Claims**

1.  A handle wafer used for a bonded wafer produced by bonding an active wafer and the handle wafer through an insulation film, the handle wafer comprising:

    a handle wafer body; and
    a polycrystalline silicon layer deposited on a side close to a bonding surface of the handle wafer body, wherein the polycrystalline silicon layer has a polycrystalline silicon grain size of 0.419 $\mu$m or less.

2.  The handle wafer for a bonded wafer according to claim 1, wherein a root-mean-square roughness Rq of the polycrystalline silicon layer measured in an area of 10 $\mu$m $\times$ 10 $\mu$m is 0.364 nm or less after the polycrystalline silicon layer is polished.

3.  The handle wafer for a bonded wafer according to claim 1 or 2, wherein the polycrystalline silicon layer is polished and BOW-bf indicating deviation from a center reference plane of the handle wafer to a median surface at a center point of the handle wafer is +16 $\mu$m or less.

4.  The handle wafer for a bonded wafer according to any one of claims 1 to 3, wherein the polycrystalline silicon layer comprises a first polycrystalline silicon layer deposited on the side close to the bonding surface of the handle wafer body and a second polycrystalline silicon layer deposited on the first polycrystalline silicon layer, and the polycrystalline silicon grain size is a polycrystalline silicon grain size of the second polycrystalline silicon layer.

5.  The handle wafer for a bonded wafer according to any one of claims 1 to 4, wherein the handle wafer body is a monocrystalline silicon wafer.

# FIG.1

ACTIVE WAFER

| PREPARE ACTIVE WAFER BODY | S11 |

↓

| GROW INSULATION FILM | S12 |

↓

| FORM ION INJECTION LAYER | S13 |

↓

| PERFORM PRE-BONDING CLEANING | S14 |

HANDLE WAFER

| PREPARE HANDLE WAFER BODY | S21 |

↓

| FORM BASE OXIDE FILM | S22 |

↓

| DEPOSITE POLYCRYSTALLINE SILICON LAYER | S23 |

↓

| POLISH | S24 |

↓

| PERFORM PRE-BONDING CLEANING | S25 |

| BOND HANDLE WAFER AND ACTIVE WAFER | S31 |

↓

| APPLY PEELING HEAT TREATMENT | S32 |

↓

| APPLY BONDING HEAT TREATMENT ON BONDED WAFER | S33 |

# F I G . 2

FIG.3

FIG.4

EP 4 163 954 A1

## INTERNATIONAL SEARCH REPORT

| International application No. |
| --- |
| PCT/JP2021/020199 |

**A. CLASSIFICATION OF SUBJECT MATTER**
H01L 21/02(2006.01)i; H01L 27/12(2006.01)i
FI: H01L21/02 B; H01L27/12 B; H01L27/12 H

According to International Patent Classification (IPC) or to both national classification and IPC

**B. FIELDS SEARCHED**

Minimum documentation searched (classification system followed by classification symbols)
H01L21/02; H01L27/12

| Documentation searched other than minimum documentation to the extent that such documents are included in the fields searched | |
| --- | --- |
| Published examined utility model applications of Japan | 1922–1996 |
| Published unexamined utility model applications of Japan | 1971–2021 |
| Registered utility model specifications of Japan | 1996–2021 |
| Published registered utility model applications of Japan | 1994–2021 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | JP 2017-228686 A (SHIN ETSU HANDOTAI CO., LTD.) 28 December 2017 (2017-12-28) paragraphs [0021]–[0057], fig. 1-7 | 1-5 |
| Y | | 2-3 |
| Y | JP 2000-138194 A (SONY CORP.) 16 May 2000 (2000-05-16) paragraphs [0002]-[0023], fig. 1-4 | 2-3 |
| Y | JP 2015-211074 A (SHIN ETSU HANDOTAI CO., LTD.) 24 November 2015 (2015-11-24) paragraphs [0018]–[0053], fig. 1-3 | 3 |
| Y | JP 2004-320050 A (SUMITOMO MITSUBISHI SILICON CORPORATION) 11 November 2004 (2004-11-11) paragraphs [0005]-[0014], fig. 1-2 | 3 |

☒ Further documents are listed in the continuation of Box C.     ☒ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 27 July 2021 (27.07.2021) | 10 August 2021 (10.08.2021) |

| Name and mailing address of the ISA/ | Authorized officer |
| --- | --- |
| Japan Patent Office 3-4-3, Kasumigaseki, Chiyoda-ku, Tokyo 100-8915, Japan | |
| | Telephone No. |

Form PCT/ISA/210 (second sheet) (January 2015)

**INTERNATIONAL SEARCH REPORT**

| International application No. |
| --- |
| PCT/JP2021/020199 |

C (Continuation).   DOCUMENTS CONSIDERED TO BE RELEVANT

| Category* | Citation of document, with indication, where appropriate, of the relevant passages | Relevant to claim No. |
| --- | --- | --- |
| X<br>Y | JP 2019-153797 A (SUNEDISON SEMICONDUCTOR LIMITED) 12 September 2019 (2019-09-12) paragraphs [0021]-[0060], fig. 3-5 | 1-2, 4-5<br>3 |
| X<br>Y | JP 2019-512870 A (SOITEC) 16 May 2019 (2019-05-16) paragraphs [0025]-[0080], fig. 1-3 | 1, 4-5<br>2-3 |
| X<br>Y | US 2018/0308928 A1 (TAIWAN SEMICONDUCTOR MANUFACTURING CO., LTD.) 25 October 2018 (2018-10-25) paragraphs [0009]-[0064], fig. 1A-2D | 1, 4-5<br>2-3 |
| A | JP 2019-216222 A (SHIN ETSU HANDOTAI CO., LTD.) 19 December 2019 (2019-12-19) entire text, all drawings | 1-5 |
| A | JP 2017-220503 A (SHIN ETSU HANDOTAI CO., LTD.) 14 December 2017 (2017-12-14) entire text, all drawings | 1-5 |

Form PCT/ISA/210 (continuation of second sheet) (January 2015)

**INTERNATIONAL SEARCH REPORT**
Information on patent family members

International application No.

PCT/JP2021/020199

| Patent Documents referred in the Report | Publication Date | Patent Family | Publication Date |
|---|---|---|---|
| JP 2017-228686 A | 28 Dec. 2017 | WO 2017/221563 A1<br>TW 201310330 A<br>CN 109075028 A | |
| JP 2000-138194 A | 16 May 2000 | (Family: none) | |
| JP 2015-211074 A | 24 Nov. 2015 | US 2017/0033002 A1<br>paragraphs [0050]-<br>[0121], fig. 1-3<br>WO 2015/162842 A1<br>EP 3136420 A1<br>TW 201543538 A<br>CN 106233426 A<br>KR 10-2016-0143693 A<br>SG 11201608563S A | |
| JP 2004-320050 A | 11 Nov. 2004 | (Family: none) | |
| JP 2019-153797 A | 12 Sep. 2019 | US 2018/0233400 A1<br>paragraphs [0023]-<br>[0061], fig. 3-5<br>WO 2016/140850 A1<br>TW 201707051 A<br>CN 107533953 A | |
| JP 2019-512870 A | 16 May 2019 | US 2019/0058031 A1<br>paragraphs [0040]-<br>[0095], fig. 1-3<br>WO 2017/144821 A1<br>FR 3048306 A1<br>TW 201742108 A<br>SG 11201807197P A<br>CN 109155276 A<br>KR 10-2019-0013696 A | |
| US 2018/0308928 A1 | 25 Oct. 2018 | (Family: none) | |
| JP 2019-216222 A | 19 Dec. 2019 | WO 2019/239763 A1<br>TW 202001988 A | |
| JP 2017-220503 A | 14 Dec. 2017 | US 2019/0221470 A1<br>entire text, all<br>drawings<br>WO 2017/212812 A1<br>TW 201310628 A<br>CN 109314040 A | |

Form PCT/ISA/210 (patent family annex) (January 2015)

**EP 4 163 954 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2015211061 A